# EUROPEAN PATENT APPLICATION

(11) **EP 3 070 702 A1**
(43) Date of publication of application: **21.09.2016**
(21) Application number: 14853128.8
(22) Date of filing: 25.07.2014
(51) Int. Cl.: G09F 9/33, G09F 9/35, G02F 1/1335

(54) **DISPLAY PANEL, DISPLAY METHOD THEREOF, AND DISPLAY APPARATUS**

(30) Priority: 15.11.2013 CN 201310571898
(71) Applicant: BOE Technology Group Co., Ltd., Beijing 100015 (CN); Beijing BOE Optoelectronics Technology Co., Ltd., Beijing 100176 (CN)
(72) Inventor: GUO, Renwei, Beijing 100176 (CN); DONG, Xue, Beijing 100176 (CN); LIU, Peng, Beijing 100176 (CN)
(74) Representative: Cohausz & Florack
(86) International application number: PCT/CN2014/083004
(87) International publication number: WO 2015/070639

(57) **Abstract**

The present invention provides a display panel and a display method thereof, and a display device. The display panel comprises a plurality of sub-pixel arrays, each sub-pixel array is composed of ten sub-pixels arranged in two rows and five columns, the ten sub-pixels of each sub-pixel array include six color sub-pixels and four compensation sub-pixels, the six color sub-pixels include two red sub-pixel, two green sub-pixel and two blue sub-pixel, the four compensation sub-pixels include two brightness compensation sub-pixels and two chromaticity compensation sub-pixels, and the sub-pixels with the same color are not adjacent to each other in a row direction and a column direction.

## Description

### CROSS-REFERENCE TO RELATED APPLICATION

This application claims priority to Chinese Patent Application No. 201310571898.3, filed on November 15, 2013, in the Chinese Intellectual Property Office, the disclosure of which is incorporated by reference herein in its entirety.

### FIELD OF THE INVENTION

The present invention relates to the field of display technology, and in particular, relates to a display panel and a display method thereof and a display device.

### BACKGROUND OF THE INVENTION

In a conventional liquid crystal display device or organic light emitting diode (OLED) display device, each point (pixel) displays colors by a plurality of sub-pixels through light mixing, e.g. each pixel is composed of a red sub-pixel, a green sub-pixel and a blue sub-pixel (i.e., in RGB mode).

To improve the visual effect, the requirement for resolution (the number of pixels in a unit size) of a display device is increasingly high, this requires increasingly small size of the sub-pixels, but the size of the sub-pixels cannot be infinitely reduced due to process limitation.

To improve the display effect under the condition that the size of the sub-pixels is definite, a display device of a Pentile mode is proposed. In the display device of the Pentile mode, the number of sub-pixels of part of colors (e.g. red sub-pixels and blue sub-pixels) is halved, meanwhile, in the display device, the sub-pixels of different colors are virtualized as in different "layers", each layer is divided into a plurality of sampling areas, the divided sampling areas of each layer are not superposed, and then the content to be displayed by each sub-pixel is calculated by using an area ratio of the sampling areas. A part of the sub-pixels in the display device of the Pentile mode are "shared", so that a resolution higher than the practical resolution is achieved on the visual effect.

However, the display effect of the existing display device of the Pentile mode is still not ideal. Since the number of the sub-pixels of part of colors is halved, the sub-pixels of various colors are not uniformly distributed, and the problems of serrated grains, latticed spots, unclear display of small contents and the like are easily caused. Meanwhile, due to a calculation mode of "layer and region divisions", a complex calculation process is needed for calculating the content which needs to be displayed by each sub-pixel, and the calculation quantity is large.

### SUMMARY OF THE INVENTION

For solving the technical problems of poor display effect and large calculation quantity in the existing high-resolution display technology, the present invention provides a display panel and a display method thereof and a display device with high resolution, good display effect and small required calculation quantity.

According to an aspect of the present invention, there is provided a display panel comprising a plurality of sub-pixel arrays, each sub-pixel array is composed of ten sub-pixels arranged in two rows and five columns, the ten sub-pixels of each sub-pixel array include six color sub-pixels and four compensation sub-pixels, the six color sub-pixels include two red sub-pixels, two green sub-pixels and two blue sub-pixels, and the four compensation sub-pixels include two brightness compensation sub-pixels and two chromaticity compensation sub-pixels.

The sub-pixels with the same color are not adjacent to each other in a row direction and a column direction.

The above-mentioned "row" and "column" are for a matrix composed of a plurality of sub-pixels, the sub-pixels are arranged in a plurality of parallel straight lines along both the "row direction" and the "column direction", and the "row" is perpendicular to the "column". Accordingly, the "row" and the "column" only indicate two opposite directions, and are irrelevant with the shape (rectangular, circular or special-shaped) of the sub-pixels and the placement manner (placed vertically, placed horizontally, upright, inverted or the like) of the display panel and the arrangement modes of a gate line and a data line. For example, each line of sub-pixels parallel to the gate line may be considered as a "row", or each line of sub-pixels parallel to the data line may be considered as a "row". Further, for example, when a display panel is placed normally, each line of sub-pixels parallel to the ground may be considered as a "row", or each line of sub-pixels perpendicular to the ground may be considered as a "row".

In the display panel, the brightness compensation sub-pixel may be a white sub-pixel; the chromaticity compensation sub-pixel may be a yellow sub-pixel or a cyan sub-pixel.

The sub-pixels in the sub-pixel array may have an arrangement mode of any one of the following fifteen modes: 1) a first row from left to right orderly comprises R, B, G, X and Y, and a second row from left to right orderly comprises X, Y, R, B and G; 2) a first row from left to right orderly comprises B, R, G, X and Y, and a second row from left to right orderly comprises X, Y, B, R and G; 3) a first row from left to right orderly comprises B, R, G, X and Y, and a second row from left to right orderly comprises Y, X, B, G and R; 4) a first row from left to right orderly comprises R, G, Y, B and Y, and a second row from left to right orderly comprises X, B, X, R and G; 5) a first row from left to right orderly comprises R, B, Y, R and Y, and a second row from left to right orderly comprises X, G, X, B and G; 6) a first row from left to right orderly comprises R, B, Y, R and G, and a second row from left to right orderly comprises X, G, X, B and Y; 7) a first row from left to right orderly comprises R, G, Y, X and Y, and a second row from left to right orderly comprises B, X, B, R and G; 8) a first row from left to right orderly comprises X, G, Y, R and Y, and a second row from left to right orderly comprises B, R, B, X and G; 9) a first row from left to right orderly comprises X, B, Y, R and Y, and a second row from left to right orderly comprises G, R, B, X and G; 10) a first row from left to right orderly comprises R, G, Y, X and Y, and a second row from left to right orderly comprises B, X, R, B and G; 11) a first row from left to right orderly comprises X, G, Y, B and Y, and a second row from left to right orderly comprises B, R, X, R and G; 12) a first row from left to right orderly comprises X, B, Y, B and Y, and a second row from left to right orderly comprises G, R, X, R and G; 13) a first row from left to right orderly comprises R, G, Y, X and Y, and a second row from left to right orderly comprises B, X, G, B and R; 14) a first row from left to right orderly comprises X, R, Y, B and Y, and a second row from left to right orderly comprises B, G, R, X and G; and 15) a first row from left to right orderly comprises X, B, Y, B and Y, and a second row from left to right orderly comprises G, R, G, X and R, wherein R indicates the red sub-pixel, G indicates the green sub-pixel, B indicates the blue sub-pixel, one of X and Y indicates the brightness compensation sub-pixel, and the other one indicates the chromaticity compensation sub-pixel.

In each sub-pixel array, colors of five sub-pixels in any one of the rows may be different from each other.

In any one of the rows of each sub-pixel array, three color sub-pixels may be arranged together and two compensation sub-pixels may be arranged together; the compensation sub-pixels arranged together in two rows of each sub-pixel array may be provided at two ends of the sub-pixel array, respectively.

The plurality of sub-pixel arrays in the display panel may be repeatedly arranged row by row and column by column, so that the sub-pixel array, as a repeating unit, is arranged throughout the display panel.

The display panel may be an organic light emitting diode display panel, each sub-pixel comprises a light emitting unit, and colors of light emitted by the light emitting units correspond to colors of the three color sub-pixels and the two compensation sub-pixels.

The display panel may be a liquid crystal display panel, each sub-pixel comprises a filter unit, and colors of light penetrating through the filter units correspond to colors of the three color sub-pixels and the two compensation sub-pixels.

According to another aspect of the present invention, there is provided a display device, comprising the above display panel.

In the display panel and the display device of the present invention, the sub-pixels of each color are equal in number and are uniformly distributed, so that serrated grains, latticed spots and the like are not produced. Meanwhile, the sub-pixels of each color are arranged in a specific manner, so that a higher resolution may be realized on the visual effect, and the calculation quantity required in the display process is small. In addition, two different compensation sub-pixels are comprised, so that the brightness and chromaticity compensations may be performed, and a better display effect is achieved.

According to yet another aspect of the present invention, there is provided a display method of the above display panel, comprising steps of: displaying a required color component of red, green or blue at each sub-pixel position, wherein this step comprises causing a plurality of color sub-pixels with the same color near a sub-pixel position to display, so that the required color component is displayed at the sub-pixel position under an average effect of the color sub-pixels with the same color; and performing display compensation on each sub-pixel position, wherein this step comprises: performing display compensation on a sub-pixel position by using a plurality of compensation sub-pixels with a required color near the sub-pixel position.

In the display method, when a color component identical to the sub-pixel color of a sub-pixel position needs to be displayed at the sub-pixel position, the plurality of color sub-pixels with the same color near the sub-pixel position include a color sub-pixel at the sub-pixel position and a plurality of color sub-pixels with the color around the sub-pixel position. When a color component different from the sub-pixel color of a sub-pixel position needs to be displayed at the sub-pixel position, the plurality of color sub-pixels with the same color near the sub-pixel position include a plurality of color sub-pixels with a required color around the sub-pixel position.

When a color component identical to the sub-pixel color of a sub-pixel position needs to be displayed at the sub-pixel position, the plurality of color sub-pixels with the color around the sub-pixel position may include: two color sub-pixels with the color in the column of the sub-pixel position and closest to the sub-pixel position; and four color sub-pixels with the color respectively in two rows adjacent to the row of the sub-pixel position, and respectively on two sides of the sub-pixel position in the row direction and closest to the sub-pixel position.

When a color component different from the sub-pixel color of a sub-pixel position needs to be displayed at the sub-pixel position, the plurality of color sub-pixels with a required color around the sub-pixel position may include: one color sub-pixel with the required color in the same row as the sub-pixel position and closest to the sub-pixel position; and two color sub-pixels with the required color in two rows adjacent to the row of the sub-pixel position and closest to the sub-pixel position in the row direction.

When a sub-pixel position needs display compensation and the compensation sub-pixels for compensation have a color the same as that of the sub-pixel at the sub-pixel position, the plurality of compensation sub-pixels with a required color near the sub-pixel position include a compensation sub-pixel at the sub-pixel position and a plurality of compensation sub-pixels with the color around the sub-pixel position. When a sub-pixel position needs display compensation and the compensation sub-pixels for compensation have a color different from that of the sub-pixel at the sub-pixel position, the plurality of compensation sub-pixels with a required color near the sub-pixel position include a plurality of compensation sub-pixels with the required color around the sub-pixel position.

When a sub-pixel position needs display compensation and the color of the compensation sub-pixels for compensation is the same as the color of the sub-pixel at the sub-pixel position, the plurality of compensation sub-pixels with the color around the sub-pixel position include: two compensation sub-pixels with the color in the column of the sub-pixel position and closest to the sub-pixel position; and four compensation sub-pixels with the color respectively in two rows adjacent to the row of the sub-pixel position, and respectively on two sides of the sub-pixel position in the row direction and closest to the sub-pixel position.

When a sub-pixel position needs display compensation and the color of the compensation sub-pixels for compensation is different from the color of the sub-pixel at the sub-pixel position, the plurality of compensation sub-pixels with the required color around the sub-pixel position include: one compensation sub-pixel with the required color in the same row as the sub-pixel position and closest to the sub-pixel position; and two compensation sub-pixels with the required color in two rows adjacent to the row of the sub-pixel position and closest to the sub-pixel position in the row direction.

In the display method of the present invention, any of all color components of red, green and blue may be displayed at each sub-pixel position (e.g. a blue component may be displayed at a red sub-pixel position by blue sub-pixels near the red sub-pixel position), i.e., a complete content may be displayed at each sub-pixel position, which is equivalent to a pixel, and thus the resolution on the visual effect is greatly improved. Moreover, the content displayed at each sub-pixel position is an average result of a plurality of sub-pixels near the sub-pixel position, and thus the displayed color is uniform and soft and the display effect is good. In addition, each sub-pixel position is used as a unit for displaying, and the contents which need to be displayed by the sub-pixels near the sub-pixel position are correspondingly calculated, so that complex calculation of "divisions of layer and region" is not needed, the calculation quantity is small, and the method is easy to be implemented. Meanwhile, due to the two different compensation sub-pixels, the brightness and chromaticity compensations may be performed, and a better display effect is achieved.

### BRIEF DESCRIPTION OF THE DRAWINGS

Fig. 1 is a schematic diagram of a sub-pixel arrangement mode of a display panel of an embodiment of the present invention.
Fig. 2 is a schematic diagram of sub-pixel arrangement modes in fifteen sub-pixel arrays of a display panel of an embodiment of the present invention.
Fig. 3 is a schematic diagram illustrating a surrounding sub-pixel distribution mode of a sub-pixel arrangement mode in a display panel of an embodiment of the present invention.
Fig. 4 is a schematic diagram illustrating another surrounding sub-pixel distribution mode of a sub-pixel arrangement mode in a display panel of an embodiment of the present invention.
Fig. 5 is a schematic diagram illustrating another surrounding sub-pixel distribution mode of a sub-pixel arrangement mode in a display panel of an embodiment of the present invention.
Fig. 6 is a schematic diagram illustrating another surrounding sub-pixel distribution mode of a sub-pixel arrangement mode in a display panel of an embodiment of the present invention.

### DESCRIPTION OF THE PREFERRED EMBODIMENT

To make those skilled in the art better understand the technical solutions of the present invention, the present invention will be further described in detail below in combination with the accompanying drawings and specific implementations. In the embodiments and drawings of the present invention, for ease of description, X indicates a brightness compensation sub-pixel, and Y indicates a chromaticity compensation sub-pixel. Actually, X and Y are only required to indicate different compensation sub-pixels, respectively, i.e., Y may indicate a brightness compensation sub-pixel, and X may indicate a chromaticity compensation sub-pixel.

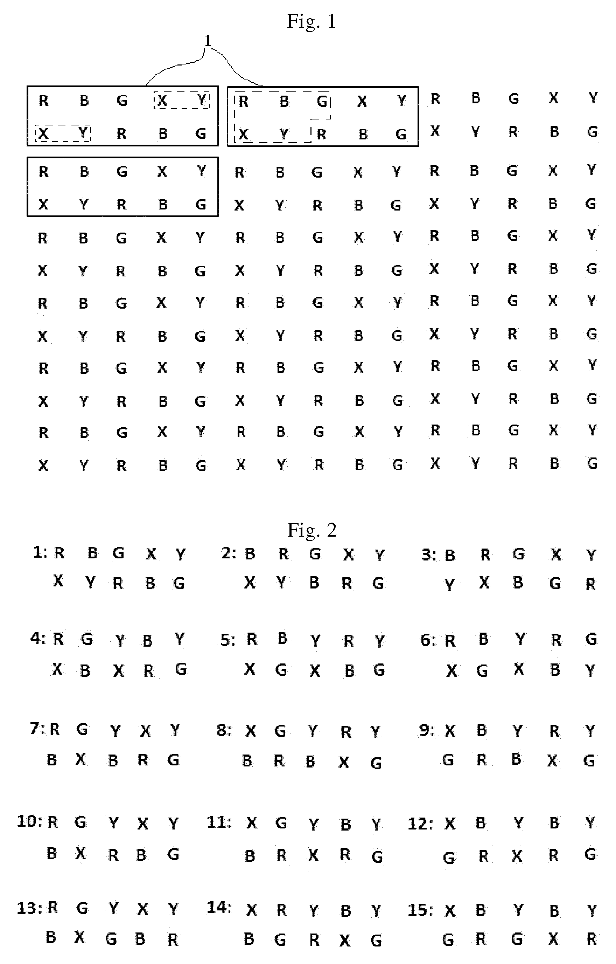

As shown in Fig. 1, a display panel of an embodiment of the present invention comprises a plurality of sub-pixel arrays 1, each of which is composed of ten sub-pixels arranged in two rows and five columns. In each sub-pixel array 1, the ten sub-pixels include six color sub-pixels and four compensation sub-pixels. The six color sub-pixels include two red sub-pixels R, two green sub-pixels G and two blue sub-pixels B, the four compensation sub-pixels include two brightness compensation sub-pixels X and two chromaticity compensation sub-pixels Y, and the sub-pixels with the same color (color sub-pixels with the same color or compensation sub-pixels with the same color) are not adjacent to each other (adjacent to each other refers to leaning against each other without intervals therebetween) in the row direction and the column direction.

That is to say, the display panel of the embodiment of the present invention comprises five kinds of sub-pixels, i.e., three kinds of red, green and blue color sub-pixels for displaying required color components and the brightness compensation sub-pixel X and the chromaticity compensation sub-pixel Y for display compensation. Different from the conventional display panel in which one pixel unit is composed of five sub-pixels, in the display panel of the embodiment, one sub-pixel array 1 is composed of ten sub-pixels and then a plurality of sub-pixel arrays 1 are arranged into a matrix to finally form the sub-pixel array. That is to say, each sub-pixel array 1 (comprising ten sub-pixels) may be regarded as a "point", and the "points" are arranged into a matrix.

For example, the sub-pixel array 1, as a repeating unit, is arranged throughout the display panel, i.e., the plurality of the sub-pixel arrays 1 are repeatedly arranged row by row and column by column.

In the display panel of the embodiment, the sub-pixels of each color are equal in number and are uniformly distributed, so that serrated grains, latticed spots and the like are not produced. Meanwhile, the sub-pixels of each color are arranged in a specific manner, so that a higher resolution may be realized on the visual effect, and the calculation quantity in the display process is small. In addition, two kinds of compensation sub-pixels are comprised, so that the brightness compensation and the chromaticity compensation may be performed simultaneously, and the display effect is good.

For example, a sub-pixel arrangement mode in the sub-pixel array 1 may be any one of fifteen kinds shown in Fig. 2. Researches discover that, the fifteen kinds of arrangement modes may achieve good display effect.

As shown in Fig. 1, in each sub-pixel array 1 of the display panel, the colors of five sub-pixels in any one of the rows may be different from one another. That is to say, in each sub-pixel array 1 shown in Fig. 1, there are no sub-pixels of the same kind in each row, and five different kinds of sub-pixels are provided in each row. Such distribution of the sub-pixels in the sub-pixel array 1 is more uniform and may achieve better display effect.

In addition, as shown in Fig. 1, in any one of the rows in each sub-pixel array 1, three color sub-pixels may be arranged together, and two compensation sub-pixels may be arranged together. The compensation sub-pixels arranged together in two rows of each sub-pixel array may be provided at two ends of the sub-pixel array. That is to say, as shown by dashed boxes in the sub-pixel array 1 at the upper left corner of Fig. 1, among five different sub-pixels in each row of the sub-pixel array 1, three color sub-pixels are arranged together and provided at one end, two compensation sub-pixels are arranged together and provided at the other end, and the compensation sub-pixels in two rows are provided at two different ends respectively. As such, as shown by dashed boxes in the second sub-pixel array 1 at the upper left of Fig. 1, five different sub-pixels arranged together constitute a "block", so that better light mixing effect may be achieved among the five sub-pixels and distances between the sub-pixels are prevented from being too large.

On the other hand, as shown in the fourth through fifteenth arrangement modes shown in Fig. 2, the sub-pixels with the same color may be arranged in one row of the sub-pixel array 1.

For example, the brightness compensation sub-pixel X is a white sub-pixel, and the chromaticity compensation sub-pixel Y is a yellow sub-pixel or a cyan sub-pixel. The above kinds of the sub-pixels may play a role of display compensation, the yellow sub-pixel may be used for improving the color gamut of the display panel, and the cyan sub-pixel may compensate the blue color. Of course, the brightness and chromaticity compensation sub-pixels may be any other colors in the visible range, as long as the compensation sub-pixels can play the role of corresponding compensation.

Each sub-pixel in the display panel may independently emit light with required color and brightness. Generally, the sub-pixels are controlled by a thin-film transistor array (active drive array), each sub-pixel corresponds to at least one thin-film transistor (for an organic light emitting diode display device, each sub-pixel corresponds to a plurality of thin-film transistors), and the thin-film transistors are arranged to form an array and controlled by gate lines and data lines.

In some embodiments, the display panel may be an organic light emitting diode display panel, each sub-pixel comprises a light emitting unit, and the colors of light emitted by the light emitting units of the sub-pixels correspond to the colors of the three color sub-pixels and the two compensation sub-pixels.

That is to say, the display panel of this embodiment may be an organic light emitting diode display panel, in which an organic light emitting diode (light emitting unit) is provided at each sub-pixel, the organic light emitting diodes may emit light with different colors (which may be realized by using different organic light emitting layers), and the color of light emitted by each organic light emitting diode is the same as that of the sub-pixel where the organic light emitting diode is located, e.g. the organic light emitting diode at the red sub-pixel emits red light.

In other embodiments, the display panel may also be a liquid crystal display panel, each sub-pixel of the display panel comprises a filter unit, and the colors of light penetrating through the filter units of the sub-pixels correspond to the colors of three color sub-pixels and two compensation sub-pixels.

That is to say, the display panel of this embodiment may also be a liquid crystal display panel, the liquid crystal display panel itself does not emit light, and light emitted from a back light source is filtered to realize display, wherein a color filter membrane (filter unit) with different color is arranged at each sub-pixel, light penetrating through the color filter membrane may be converted to the corresponding color, and the color of the color filter membrane at each sub-pixel is the same as the color of the sub-pixel, e.g. the color filter membrane at the red sub-pixel is red, etc.

Certainly, other types of display panels are also feasible, as long as light with corresponding colors are emitted at the sub-pixels, and the different types of display panels may adopt known structures and therefore are no longer described in detail herein.

An embodiment of the present invention further provides a display device, comprising the above-mentioned display panel.

Moreover, an embodiment of the present invention further provides a display method of the above-mentioned display panel, comprising the following steps of: displaying a required color component of red, green or blue at each sub-pixel position, wherein this step comprises causing a plurality of color sub-pixels with the same color near a sub-pixel position to display, so that the required color component is displayed at the sub-pixel position under the average effect of the color sub-pixels with the same color; and performing display compensation on a sub-pixel position by using a plurality of compensation sub-pixels with a required color near the sub-pixel position.

In this case, the above two steps indicate two operations in the display process and are used for displaying the components of red, green and blue and performing display compensation, respectively, and thus the two steps unnecessarily involve a precedence relationship in time sequence.

It is thus clear that, in the display method of the embodiment of the present invention, any of all required color components of red, green and blue may be displayed (i.e., red, green or blue color component may be displayed) at each sub-pixel position (rather than each sub-pixel), and each color component of each sub-pixel position is displayed by a plurality of color sub-pixels with the corresponding color near the sub-pixel position together, so that the required color component is displayed at the sub-pixel position under the average effect of the color sub-pixels. Meanwhile, in the embodiment, display compensation (brightness compensation and/or chromaticity compensation) is performed on each sub-pixel position by using the compensation sub-pixels so as to improve the display effect, and each sub-pixel position is compensated by a plurality of the compensation sub-pixels near the sub-pixel position.

The display method of the embodiment has the following advantages: 1, any of all color components may be displayed at each sub-pixel position (e.g. a blue component may be displayed at a red sub-pixel position by blue sub-pixels B near the red sub-pixel position), namely, a complete content may be displayed at each sub-pixel position, and each sub-pixel position is equivalent to one "pixel", so that the resolution on the visual effect is greatly improved; 2, the brightness compensation and the chromaticity compensation may be performed at each sub-pixel position, so that a good display effect is achieved by the two kinds of display compensation; 3, the content displayed (compensated) at each sub-pixel position is an average result of a plurality of sub-pixels near the sub-pixel position, so the displayed color is uniform and soft and the display effect is good; and 4, each sub-pixel position is used as a reference for displaying in the display method of this embodiment, and the contents to be displayed by the sub-pixels near the sub-pixel position are correspondingly calculated, so that the content to be displayed by each sub-pixel may be directly calculated, complex calculation of "layer and region divisions" is not needed, the calculation quantity is small, and the method is easy to be implemented.

In the display method of the embodiment, for example, when a color component identical to the sub-pixel color of a sub-pixel position needs to be displayed at the sub-pixel position (e.g. a red component needs to be displayed at the red sub-pixel position), the plurality of color sub-pixels with the same color near the sub-pixel position include a color sub-pixel (the red sub-pixel R) at the sub-pixel position and a plurality of color sub-pixels (red sub-pixels R) with the color around the sub-pixel position.

In addition, when a color component different from the sub-pixel color of a sub-pixel position needs to be displayed at the sub-pixel position (e.g. a green component needs to be displayed at the red sub-pixel position), the plurality of color sub-pixels with the same color near the sub-pixel position include a plurality of color sub-pixels with a required color (green sub-pixels G) around the sub-pixel position. That is to say, "the color sub-pixels near the sub-pixel position" do not include the sub-pixel at the sub-pixel position (due to different color).

According to different requirements, the selection method of "the color sub-pixels near the sub-pixel position" is diverse.

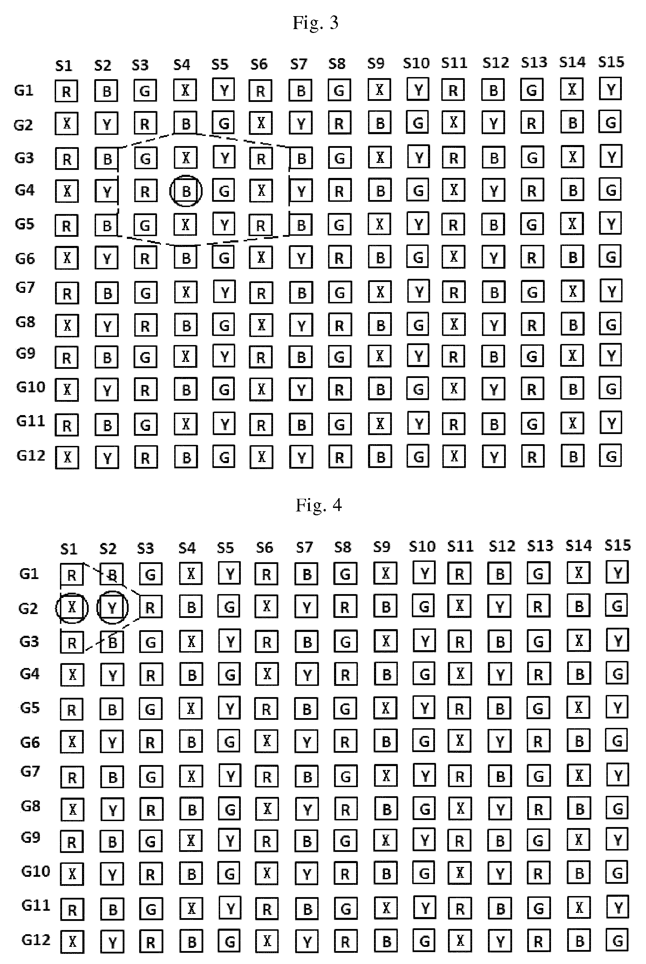

For example, as shown in Fig. 3, when a color component identical to the sub-pixel color of a sub-pixel position needs to be displayed at the sub-pixel position, the plurality of color sub-pixels with the color around the sub-pixel position include two color sub-pixels with the color in the column of the sub-pixel position and closest to the sub-pixel position, and four color sub-pixels with the color respectively in two rows adjacent to the row of the sub-pixel position, and respectively on two sides of the sub-pixel position in the row direction and closest to the sub-pixel position.

That is to say, as shown in Fig. 3, when a blue component needs to be displayed at the circled blue sub-pixel position with coordinate (S4, G4) in the figure, the blue component is displayed by the color sub-pixels around the blue sub-pixel position besides the blue sub-pixel position itself, the "color sub-pixels around the blue sub-pixel position" include two blue sub-pixels B in the same column as the blue sub-pixel position and closest to the blue sub-pixel position, and four blue sub-pixels B in two rows above and below the row of the blue sub-pixel position (two in each row), respectively on right and left sides of the blue sub-pixel position (two on each side) and closest to the blue sub-pixel position. That is, the "color sub-pixels around the blue sub-pixel position" may include six blue sub-pixels B connected by dotted lines in the figure, i.e., six blue sub-pixels B with coordinates (S2, G3), (S4, G2), (S7, G3), (S7, G5), (S4, G6) and (S2, G5). These "color sub-pixels around the blue sub-pixel position" constitute a "hexagon" surrounding the blue sub-pixel position, and four blue sub-pixels B with coordinates (S2, G3), (S7, G3), (S7, G5) and (S2, G5) constitute a "rectangle".

For example, when a color component different from the sub-pixel color of a sub-pixel position needs to be displayed at the sub-pixel position, the plurality of color sub-pixels with a required color around the sub-pixel position includes one color sub-pixel with the required color in the same row as the sub-pixel position and closest to the sub-pixel position, and two color sub-pixels with the required color in two rows adjacent to the row of the sub-pixel position and closest to the sub-pixel position in the row direction.

That is to say, as shown in Fig. 4, when a red component needs to be displayed at the circled brightness compensation sub-pixel position with coordinate (S1, G2) or the circled chromaticity compensation sub-pixel position with coordinate (S2, G2) in the figure, the "color sub-pixels around the sub-pixel position" include one color sub-pixel with the required color in the same row as the sub-pixel position and closest to the sub-pixel position (i.e. the red sub-pixel R with coordinate (S3, G2)), and two color sub-pixels with the required color in two rows above and below the row of the sub-pixel position and closest to the sub-pixel position in the row direction (i.e. the red sub-pixels R with coordinates (S1, G1) and (S1, G3)). It is thus clear that, when the above condition is satisfied, the three "color sub-pixels around the sub-pixel position" definitely constitute an "isosceles triangle", the bottom edge of the isosceles triangle is parallel to the column direction, and the brightness compensation sub-pixel position or the chromaticity compensation sub-pixel position is located in the triangle.

The above selection method of the "color sub-pixels around the sub-pixel position" may ensure that the selected color sub-pixels are close to the sub-pixel position and are not too much in number, so that good display effect may be achieved and over large calculation quantity during display may be avoided.

In the display method of the embodiment, for example, when a sub-pixel position needs display compensation and the color of the compensation sub-pixels for compensation is the same as the color of the sub-pixel at the sub-pixel position, the plurality of compensation sub-pixels with the color near the sub-pixel position include a compensation sub-pixel at the sub-pixel position and a plurality of compensation sub-pixels with the color around the sub-pixel position.

For example, when a sub-pixel position needs display compensation and the color of the compensation sub-pixels for compensation is different from the color of the sub-pixel at the sub-pixel position, the plurality of compensation sub-pixels with the required color near the sub-pixel position include a plurality of compensation sub-pixels with the required color around the sub-pixel position.

That is to say, similar to the condition that the color components are displayed, when display compensation is performed, the selection method of the plurality of compensation sub-pixels near the sub-pixel position is different according to different types of the sub-pixels at the sub-pixel position to be compensated, and the plurality of compensation sub-pixels near the sub-pixel position may include the sub-pixel at the sub-pixel position (when the brightness compensation is performed on the brightness compensation sub-pixel position, or the chromaticity compensation is performed on the chromaticity compensation sub-pixel position) or not include the sub-pixel at the sub-pixel position (when the brightness compensation is performed on the color sub-pixel position or the chromaticity compensation sub-pixel position, or when the chromaticity compensation is performed on the color sub-pixel position or the brightness compensation sub-pixel position).

Similar to the condition that the color components are displayed, when display compensation is performed, the selection method of the "compensation sub-pixels around the sub-pixel position" is also diverse.

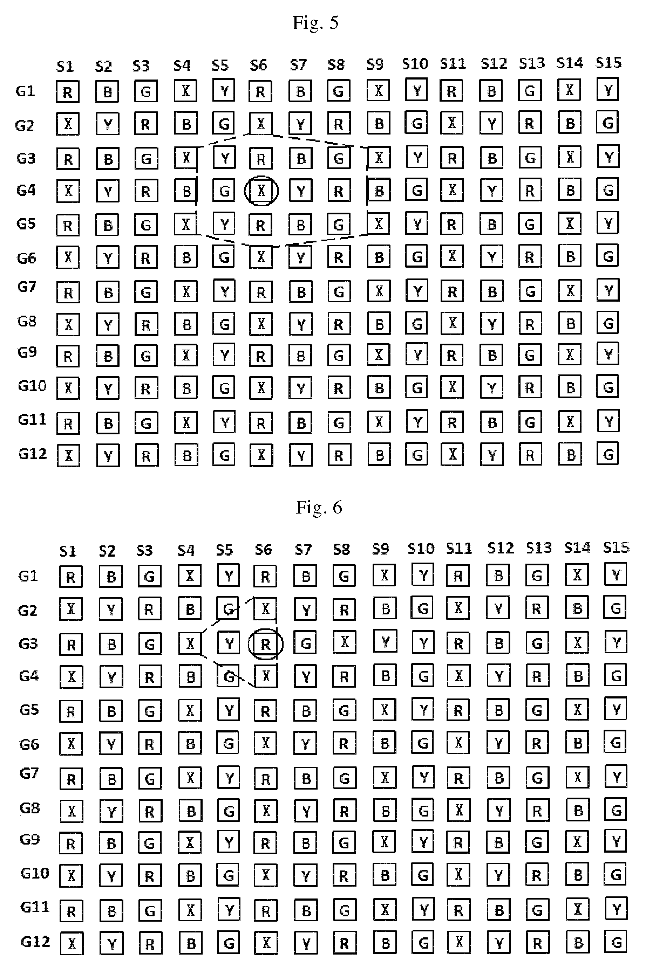

As shown in Fig. 5, when a sub-pixel position needs display compensation and the color of the compensation sub-pixels for compensation is the same as the color of the sub-pixel at the sub-pixel position, the plurality of compensation sub-pixels around the sub-pixel position may include two compensation sub-pixels with the color in the column of the sub-pixel position and closest to the sub-pixel position, and four compensation sub-pixels with the color respectively in two rows adjacent to the row of the sub-pixel position, and respectively on two sides of the sub-pixel position in the row direction and closest to the sub-pixel position.

That is to say, as shown in Fig. 5, when compensation having the same type as a compensation sub-pixel is performed on the compensation sub-pixel position, e.g., when the brightness compensation is performed on the circled brightness compensation sub-pixel position with coordinate (S6, G4) in the figure, the "compensation sub-pixels around sub-pixel position" may include six brightness compensation sub-pixels X connected by dotted lines in the figure, i.e., six brightness compensation sub-pixels X with coordinates (S4, G3), (S6, G2), (S9, G3), (S9, G5), (S6, G6) and (S4, G5).

It should be noted that, the case where the chromaticity compensation is performed on the chromaticity compensation sub-pixel Y is similar to the above, and detailed description thereto is omitted herein.

As shown in Fig. 6, when a sub-pixel position needs display compensation and the color of the compensation sub-pixels for compensation is different from the color of the sub-pixel at the sub-pixel position, the plurality of compensation sub-pixels around the sub-pixel position include one compensation sub-pixel with the required color in the same row as the sub-pixel position and closest to the sub-pixel position, and two compensation sub-pixels with the required color in two rows adjacent to the row of the sub-pixel position and closest to the sub-pixel position in the row direction.

That is to say, as shown in Fig. 6, when a sub-pixel position is compensated in different type from the sub-pixel at the sub-pixel position, for example, when the brightness compensation is performed on the circled red sub-pixel position with coordinate (S6, G3), the "compensation sub-pixels around the sub-pixel position" may include three brightness compensation sub-pixels X constituting an "isosceles triangle" and connected by dotted lines in the figure, i.e., three brightness compensation sub-pixels X with coordinates (S6, G2), (S6, G4) and (S4, G3).

It should be noted that, the case where the brightness compensation is performed on the color sub-pixel position with other color or the chromaticity compensation sub-pixel Y, or the chromaticity compensation is performed on the color sub-pixel position or the brightness compensation sub-pixel X is similar to the above, and detailed description thereto is omitted herein.

It should be understood that, in the embodiment, the content of each sub-pixel position is displayed (compensated) by a plurality of sub-pixels together, and accordingly, each sub-pixel is not only used for display at a position, but also used for displays at a plurality of sub-pixel positions. For example, as shown in Fig. 4, the red sub-pixel R with coordinate (S3, G2) is at work when a red component needs to be displayed at the sub-pixel position with coordinate (S2, G2) and is also at work when a red component needs to be displayed at the sub-pixel position with coordinate (S1, G2). Therefore, the content to be displayed by any one of sub-pixels is determined together by the contents to be displayed by a plurality of sub-pixel positions corresponding to the sub-pixel.

It should be understood that, the selection method of the "color (compensation) sub-pixels around sub-pixel position" above is not used for limiting the embodiments of the present invention, e.g., for the case shown in Fig. 5, when the brightness compensation is performed on the sub-pixel position with coordinate (S6, G4), the six brightness compensation sub-pixels X constituting the "hexagon" in the figure may not be utilized, while the four brightness compensation sub-pixels X constituting the above "rectangle" may be utilized. In a word, color (compensation) sub-pixels relatively close to a certain sub-pixel position may be the "color (compensation) sub-pixels around the sub-pixel position".

It should be understood that, the selection method of the "color (compensation) sub-pixels around the sub-pixel position" above may be changed at any time according to the specific displayed contents. For example, in different frames of pictures, "the color (compensation) sub-pixels around the sub-pixel position" used when the same color is displayed at the same sub-pixel position may be different (e.g. three sub-pixels are used in the first frame of picture, and four sub-pixels are used in the second frame of picture). Further, in a frame of picture, the selection methods of the "color (compensation) sub-pixels around the sub-pixel position" for different sub-pixel positions may also be different.

It should be understood that, when the "color (compensation) sub-pixels around the sub-pixel position" are determined, the selection methods of the "color (compensation) sub-pixels around the sub-pixel position" for the sub-pixel positions close to the edges of the display panel may be different from above. For example, there is no other sub-pixel above the top row of sub-pixel positions of the display panel, so only the sub-pixels below the top row of sub-pixel positions may be used as the "color (compensation) sub-pixels around the sub-pixel position".

It could be understood that, the above implementation ways are merely exemplary embodiments adopted for describing the principle of the present invention, but the present invention is not limited thereto. Various modifications and improvements may be made by those of ordinary skill in the art without departing from the spirit and essence of the present invention, and these modifications and improvements are contemplated as within the protection scope of the present invention.

## Claims

1. A display panel, comprising a plurality of sub-pixel arrays, wherein
each sub-pixel array is composed of ten sub-pixels arranged in two rows and five columns;
the ten sub-pixels of each sub-pixel array include six color sub-pixels and four compensation sub-pixels, the six color sub-pixels include two red sub-pixel, two green sub-pixel and two blue sub-pixel, and the four compensation sub-pixels include two brightness compensation sub-pixels and two chromaticity compensation sub-pixels; and
the sub-pixels with the same color are not adjacent to each other in a row direction and a column direction.

2. The display panel of claim 1, wherein
the brightness compensation sub-pixel is a white sub-pixel;
the chromaticity compensation sub-pixel is a yellow sub-pixel or a cyan sub-pixel.

3. The display panel of claim 1 or 2, wherein the sub-pixels in the sub-pixel array have an arrangement mode of any one of the following fifteen modes:
1) a first row from left to right orderly comprises R, B, G, X and Y, and a second row from left to right orderly comprises X, Y, R, B and G;
2) a first row from left to right orderly comprises B, R, G, X and Y, and a second row from left to right orderly comprises X, Y, B, R and G;
3) a first row from left to right orderly comprises B, R, G, X and Y, and a second row from left to right orderly comprises Y, X, B, G and R;
4) a first row from left to right orderly comprises R, G, Y, B and Y, and a second row from left to right orderly comprises X, B, X, R and G;
5) a first row from left to right orderly comprises R, B, Y, R and Y, and a second row from left to right orderly comprises X, G, X, B and G;
6) a first row from left to right orderly comprises R, B, Y, R and G, and a second row from left to right orderly comprises X, G, X, B and Y;
7) a first row from left to right orderly comprises R, G, Y, X and Y, and a second row from left to right orderly comprises B, X, B, R and G;
8) a first row from left to right orderly comprises X, G, Y, R and Y, and a second row from left to right orderly comprises B, R, B, X and G;
9) a first row from left to right orderly comprises X, B, Y, R and Y, and a second row from left to right orderly comprises G, R, B, X and G;
10) a first row from left to right orderly comprises R, G, Y, X and Y, and a second row from left to right orderly comprises B, X, R, B and G;
11) a first row from left to right orderly comprises X, G, Y, B and Y, and a second row from left to right orderly comprises B, R, X, R and G;
12) a first row from left to right orderly comprises X, B, Y, B and Y, and a second row from left to right orderly comprises G, R, X, R and G;
13) a first row from left to right orderly comprises R, G, Y, X and Y, and a second row from left to right orderly comprises B, X, G, B and R;
14) a first row from left to right orderly comprises X, R, Y, B and Y, and a second row from left to right orderly comprises B, G, R, X and G; and
15) a first row from left to right orderly comprises X, B, Y, B and Y, and a second row from left to right orderly comprises G, R, G, X and R,
wherein R indicates the red sub-pixel, G indicates the green sub-pixel, B indicates the blue sub-pixel, one of X and Y indicates the brightness compensation sub-pixel, and the other one indicates the chromaticity compensation sub-pixel.

4. The display panel of claim 1 or 2, wherein
colors of five sub-pixels in any one of the rows are different from each other in each sub-pixel array.

5. The display panel of claim 4, wherein
three color sub-pixels are arranged together and two compensation sub-pixels are arranged together in any one of the rows of each sub-pixel array;
the compensation sub-pixels arranged together in two rows of each sub-pixel array are provided at two ends of the sub-pixel array, respectively.

6. The display panel of claim 1 or 2, wherein
the plurality of sub-pixel arrays in the display panel are repeatedly arranged row by row and column by column, so that the sub-pixel array, as a repeating unit, is arranged throughout the display panel.

7. The display panel of claim 1 or 2, wherein
the display panel is an organic light emitting diode display panel, each sub-pixel comprises a light emitting unit, and colors of light emitted by the light emitting units correspond to colors of the three color sub-pixels and the two compensation sub-pixels.

8. The display panel of claim 1 or 2, wherein
the display panel is a liquid crystal display panel, each sub-pixel comprises a filter unit, and colors of light penetrating through the filter units correspond to colors of the three color sub-pixels and the two compensation sub-pixels.

9. A display device, comprising the display panel of any one of claims 1 to 8.

10. A display method of the display panel of any one of claims 1 to 8, comprising steps of:
displaying a required color component of red, green or blue at each sub-pixel position, wherein this step comprises causing a plurality of color sub-pixels with the same color near a sub-pixel position to display, so that the required color component is displayed at the sub-pixel position under an average effect of the color sub-pixels with the same color; and
performing display compensation on each sub-pixel position, wherein this step comprises performing display compensation on a sub-pixel position by using a plurality of compensation sub-pixels with a required color near the sub-pixel position.

11. The display method of claim 10, wherein
when a color component identical to the sub-pixel color of a sub-pixel position needs to be displayed at the sub-pixel position, the plurality of color sub-pixels with the same color near the sub-pixel position include a color sub-pixel at the sub-pixel position and a plurality of color sub-pixels with the color around the sub-pixel position; and
when a color component different from the sub-pixel color of a sub-pixel position needs to be displayed at the sub-pixel position, the plurality of color sub-pixels with the same color near the sub-pixel position include a plurality of color sub-pixels with a required color around the sub-pixel position.

12. The display method of claim 11, wherein when a color component identical to the sub-pixel color of a sub-pixel position needs to be displayed at the sub-pixel position, the plurality of color sub-pixels with the color around the sub-pixel position include:
two color sub-pixels with the color in the column of the sub-pixel position and closest to the sub-pixel position; and
four color sub-pixels with the color respectively in two rows adjacent to the row of the sub-pixel position, and respectively on two sides of the sub-pixel position in the row direction and closest to the sub-pixel position.

13. The display method of claim 11, wherein when a color component different from the sub-pixel color of a sub-pixel position needs to be displayed at the sub-pixel position, the plurality of color sub-pixels with a required color around the sub-pixel position include:
one color sub-pixel with the required color in the same row as the sub-pixel position and closest to the sub-pixel position; and
two color sub-pixels with the required color in two rows adjacent to the row of the sub-pixel position and closest to the sub-pixel position in the row direction.

14. The display method of claim 10, wherein
when a sub-pixel position needs display compensation and the compensation sub-pixels for compensation have a color the same as that of the sub-pixel at the sub-pixel position, the plurality of compensation sub-pixels with a required color near the sub-pixel position include a compensation sub-pixel at the sub-pixel position and a plurality of compensation sub-pixels with the color around the sub-pixel position; and
when a sub-pixel position needs display compensation and the compensation sub-pixels for compensation have a color different from that of the sub-pixel at the sub-pixel position, the plurality of compensation sub-pixels with a required color near the sub-pixel position include a plurality of compensation sub-pixels with the required color around the sub-pixel position.

15. The display method of claim 14, wherein when a sub-pixel position needs display compensation and the color of the compensation sub-pixels for compensation is the same as the color of the sub-pixel at the sub-pixel position, the plurality of compensation sub-pixels with the color around the sub-pixel position include:
two compensation sub-pixels with the color in the column of the sub-pixel position and closest to the sub-pixel position; and
four compensation sub-pixels with the color respectively in two rows adjacent to the row of the sub-pixel position, and respectively on two sides of the sub-pixel position in the row direction and closest to the sub-pixel position.

16. The display method of claim 14, wherein when a sub-pixel position needs display compensation and the color of the compensation sub-pixels for compensation is different from the color of the sub-pixel at the sub-pixel position, the plurality of compensation sub-pixels with the required color around the sub-pixel position include:
one compensation sub-pixel with the required color in the same row as the sub-pixel position and closest to the sub-pixel position; and
two compensation sub-pixels with the required color in two rows adjacent to the row of the sub-pixel position and closest to the sub-pixel position in the row direction.
